# EUROPEAN PATENT SPECIFICATION

(11) **EP 4 369 366 B1**
(45) Date of publication and mention of the grant of the patent: **09.04.2025**
(21) Application number: 23209566.1
(22) Date of filing: 13.11.2023
(51) Int. Cl.: H01F 27/40

(54) **PLANAR MAGNETIC COMPONENT**
PLANARES MAGNETISCHES BAUTEIL
COMPOSANT MAGNÉTIQUE PLAN

(30) Priority: 14.11.2022 US 202263425014 P
(43) Date of publication of application: 15.05.2024
(73) Proprietor: DELTA ELECTRONICS, INC., Taoyuan City 320023 (TW)
(72) Inventor: CHIU, Yi-Hsun, Taoyuan City 320023 (TW); CHANG, Yi-Sheng, Taoyuan City 320023 (TW); LAI, Chien-An, Taoyuan City 320023 (TW); CHU, Chia-Wei, Taoyuan City 320023 (TW)
(74) Representative: 2K Patentanwälte Blasberg Kewitz & Reichel

(56) References cited:
- EP-A1- 3 629 463
- JP-A- 2011 077 328
- US-A1- 2015 124 489
- US-B2- 10 516 339

## Description

### BACKGROUND

### Technical Field

The present disclosure relates to a planar magnetic component, and more particularly to a planar magnetic component integrated with a current transformer.

### Description of Related Art

The statements in this section merely provide background information related to the present disclosure and do not necessarily constitute prior art.

With the rapid development of the information industry, power supplies have played an indispensable role. The input voltage of information and household appliances is divided into AC voltage and DC voltage, and power supplies can generally be divided into two levels. In general, the front stage is usually an AC-to-DC converter, a power factor corrector or a DC-to-DC converter, and the rear stage is usually a resonant converter. The resonant converter is a DC-to-DC power converter, and it has a primary-side switch that turns on at zero voltage and a secondary-side rectification switch that turns off at zero current. Therefore, it has the advantages of high power and high conversion efficiency than other converters. Furthermore, using a rectification switch on the secondary side makes it easier to achieve high efficiency and high power density.

In particular, resonant converters usually include inductive components such as resonant inductors and transformers, and these inductive components are usually composed of coils, bobbins, and iron cores. Since the coil must be formed by winding copper wire on the winding frame for more than dozens of turns, and then the iron core is used to set the winding to form a closed magnetic circuit, resonant inductors and transformers usually have the fatal disadvantage of being bulky. Therefore, the size of the resonant converter cannot be effectively reduced, resulting in the problem of bulky power supply and poor power density.

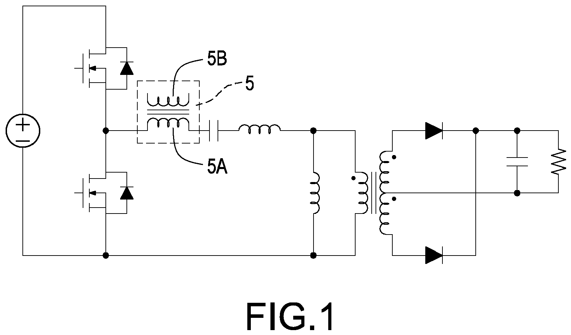

On the other contrary, in FIG. 1, which shows a circuit block diagram of a conventional current converter coupled to the resonant converter of the present disclosure. In FIG. 1, the traditional current detection is to connect a current transformer (CT) 5 in series on the primary-side path, and the current transformer 5 includes a current transformer primary-side coil 5A and a current transformer secondary-side coil 5B. The current transformer 5 usually requires the current transformer primary-side coil 5A and the current transformer secondary-side coil 5B to be wound around the current transformer core to detect the current, and therefore larger space and safety distance are usually required to meet the design requirements. Therefore, it is also impossible to effectively reduce the size of the resonant converter, resulting in the problem that the power supply is bulky and has poor power density.

JP 2011 077328 A discloses a coil component constituting a transformer of a DC-DC converter includes a heat conduction region provided to a primary-side coil substrate. The heat conduction region and a projection part of a base plate as a heat dissipation member are thermally connected to each other, to excellently perform heat transmission of heat generated by a primary-side coil conductor of the primary-side coil substrate, specifically, heat generated by a second coil part and a third coil part forming the primary-side coil conductor of the transformer to the base plate. Namely, the heat generated by the coil on the side of the primary-side coil substrate can be dissipated to the base plate not through secondary-side coils, and thereby heat dissipation effects of the primary-side coil substrate can be enhanced.

US 10 516 339 B2 discloses a power converter including a transformer with a primary and a secondary, and a capacitor and an inductor serially connected with the primary of the transformer. The capacitor, the inductor and a magnetizing inductor of the transformer form an LLC resonant circuit. The power converter further including a first current sensor and a second current sensor. The first current sensor including the inductor and is configured to sense, via the inductor, a current passing through the primary of the transformer. The second current sensor including the primary and is configured to sense, via the primary, a current passing through the magnetizing inductor of the transformer. A current passing through the secondary is determined from a difference obtained based on the sensed current passing through the primary of the transformer and the sensed current passing through the magnetizing inductor. The power converter has the advantage that it is possible to provide an accurate sensed current at a low cost without load limitation, and it is also possible to perform a cycle-by-cycle protection function since a load waveform can be restored. In addition, another power converter is also provided, which has a structure for reducing power circulation among parallel windings of the transformer.

US 2015/124489 A1 discloses an apparatus comprising a magnetic device coupled to an inductor-inductor-capacitor resonant converter, an ac current sensing circuit coupled to the magnetic device, an average current sensing circuit coupled to the ac current sensing circuit and a reference voltage source coupled to the average current sensing circuit, wherein the reference voltage source is configured such that a magnitude of an average signal from the average current sensing circuit is greater than a voltage level of the reference voltage source.

EP 3 629 463 A1 discloses a DC voltage regulator, comprising an inverter, a rectifier and an AC voltage intermediate circuit with a transformer. To improve the DC voltage converter, it is proposed that the DC voltage converter comprise an inductive DC voltage converter, the AC voltage intermediate circuit having a resonance circuit, the inductance of which essentially consists of the leakage inductance of the transformer and the inductance of the inductive current converter is formed. The invention also relates to a method for operating such a DC voltage controller, wherein semiconductors of the inverter are switched in such a way that an output voltage the inverter results in a predefinable output voltage is generated, the semiconductors being switched at least periodically at the natural frequency of the resonant circuit.

Therefore, how to design a planar magnetic component to replace the traditional magnetic component in the resonant converter and integrate the current transformer coil into the planar magnetic component to greatly reduce the size of the resonant converter has become a critical topic in this field.

### SUMMARY

In order to solve the above-mentioned problems, the present disclosure provides a planar magnetic component according to appended claims 1 and 5. Advantageous embodiments are the subject of the dependent claims.

The main purpose and effect of the present disclosure is to use the planar magnetic component in the resonant converter and integrate the current transformer coil into the planar magnetic component, so that the primary-side coil of the current transformer and the current transformer core can be omitted to reduce the contact resistance caused by the current transformer, increase efficiency, and increase power density.

It is to be understood that both the foregoing general description and the following detailed description are exemplary, and are intended to provide further explanation of the present disclosure as claimed. Other advantages and features of the present disclosure will be apparent from the following description, drawings, and claims.

### BRIEF DESCRIPTION OF DRAWINGS

The present disclosure can be more fully understood by reading the following detailed description of the embodiment, with reference made to the accompanying drawing as follows:
FIG. 1 is a circuit block diagram of a conventional current converter coupled to the resonant converter of the present disclosure.
FIG. 2A is a circuit block diagram of a resonant converter of the present disclosure.
FIG. 2B is a schematic diagram of the circuit structure of the current transformer coil coupled to a secondary-side coil of the present disclosure.
FIG. 3A is an exploded perspective view of the resonant converter of the present disclosure.
FIG. 3B is an assembled perspective view of the resonant converter of the present disclosure.
FIG. 4A to FIG. 4L are schematic diagrams of the wiring of the coil of the planar magnetic component on each layer of the circuit board according to different embodiments of the present disclosure.
FIG. 5A to FIG. 5C are schematic diagrams of the wiring of the coil of the planar magnetic component on each layer of the circuit board according to other different embodiments of the present disclosure.

### DETAILED DESCRIPTION

Reference will now be made to the drawing figures to describe the present disclosure in detail. It will be understood that the drawing figures and exemplified embodiments of present disclosure are not limited to the details thereof.

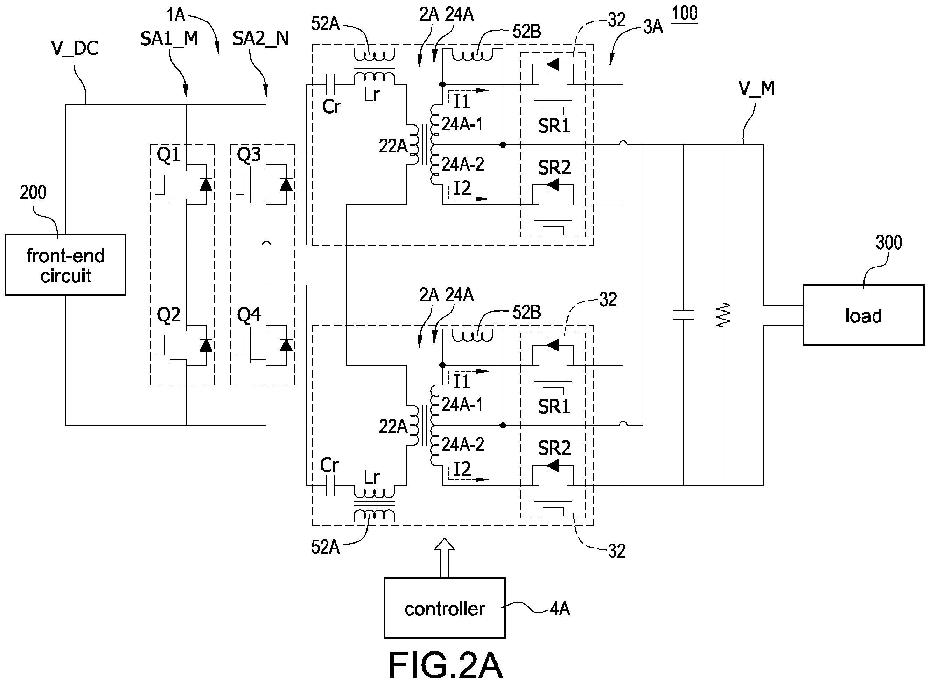

Please refer to FIG. 2A, which shows a circuit block diagram of a resonant converter of the present disclosure, and also refer to FIG. 1. The resonant converter 100 is be coupled to a front-end circuit 200 and a load 300, and the front-end circuit 200 may be a DC power supply such as an AC-to-DC converter, a power factor corrector, a DC power source, or so on. The resonant converter 100 includes a primary-side circuit 1A, at least one transformer 2A (two transformers are shown as an example), at least one secondary-side circuit 3A (two secondary-side circuits are shown as an example), and a controller 4A. The transformer 2A includes a primary-side coil 22A and a secondary-side coil 24A. Taking FIG. 1 as an example, the primary-side circuit 1A is a half-bridge architecture, including one switch bridge arm SA1_M and one resonant tank (i.e., a resonant inductor Lr and a resonant capacitor Cr), and the switch bridge arm SA1_M includes two power switches Q1, Q2 connected in series. The secondary-side circuit 3A includes two rectification circuits 32, and each rectification circuit 32 includes two rectification switches SR1, SR2. The secondary-side coil 24A of the transformer 2A includes a first winding 24A-1 and a second winding 24A-2, and the first winding 24A-1 and the second winding 24A-2 are center-tapped windings. Therefore, the resonant converter 100 can control the turning on/turning off of the rectification switches SR1, SR2 by the controller 4A, so that the first winding 24A-1 and the second winding 24A-2 are respectively coupled to the primary-side coil 22A.

In general, the controller 4A controls the switch bridge arm SA1_M and the rectification switches SR1, SR2 of the rectification circuit 32 to operate the resonant tank and the transformer 2A storing energy and releasing energy so as to convert the DC power source V_DC received by the resonant converter 100 into a main power source V_M. Incidentally, the circuit structures of the primary-side circuit 1A and the secondary-side circuit 3A are only illustrative examples. As long as the primary-side circuit 1A (such as, but not limited to, a full-bridge structure, two resonant tanks, etc.) and the secondary-side circuit 3A (such as, but not limited to, a half-bridge rectification circuit, one rectification circuit, etc.) can form the structure of the resonant converter 100, should be included in the scope of this embodiment. In one embodiment, the number of the transformers 2A is not limited to two as shown in FIG. 1, i.e., the number of the transformer 2A may be one or more than one. When the number of the transformer 2A is one, the resonant converter 100 includes one primary-side coil 22A, one first winding 24A-1, and one second winding 24A-2, and so on.

In FIG. 2A, the resonant converter 100 further includes current transformer coils 52A, 52B. Compared with the conventional current transformer 5 in FIG. 1 which includes the current transformer primary-side coil 5A and the current transformer secondary-side coil 5B, in this disclosure, since the current transformer primary-side coil 5A is integrated in the resonant inductor Lr and the secondary-side coil 24A, the present disclosure does not include the current transformer primary-side coil 5A. Moreover, the current transformer coils 52A, 52B serve as the current transformer secondary-side coil 5B for sensing the current flowing through the resonant inductor Lr and the secondary-side coil 24A. On the other hand, the current transformer coils 52A, 52B of FIG. 2A may be coupled to, for example, but not limited to, a current detection circuit (not shown). The current detection circuit can generate a voltage signal according to the current sensed by the current transformer coils 52A, 52B, so as to provide the voltage signal to the controller 4A. Therefore, the controller 4A can acquire the magnitude of the current flowing through the resonant inductor Lr and the transformer 2A through calculation of the voltage signal.

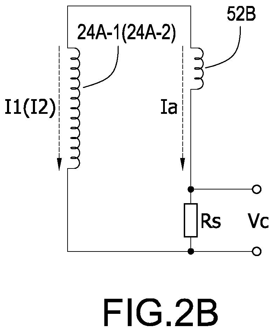

Please refer to FIG. 2B, which shows a schematic diagram of the circuit structure of the current transformer coil coupled to a secondary-side coil of the present disclosure., and also refer to FIG. 2A. One terminal of the current transformer coil 52B is coupled to one terminal of the first coil 24A-1 or the second coil 24A-2, and the other terminal of the current transformer coil 52B is coupled to a detection resistor Rs, and therefore the current transformer coil 52B and the detection resistor Rs are connected in parallel to the first coil 24A-1 or the second coil 24A-2. For convenience of explanation, the secondary-side currents flowing through the rectification switches SR1, SR2 are distinguished as a first current I1 and a second current I2 respectively. When the current transformer coil 52B is coupled to the first coil 24A-1 and the first current I1 flows through the first coil 24A-1, the current transformer coil 52B induces a sensing current Ia. The sensing current Ia flowing through the detection resistor Rs can generate a cross-voltage Vc on the detection resistor Rs, and a back-end coupled current detection circuit (not shown) can generate a voltage signal according to the cross-voltage Vc. Furthermore, since the voltage across the first coil 24A-1 will be equal to the voltage across the current transformer coil 52B and the detection resistor Rs, and the first current I1 has a corresponding relationship with the sensing current Ia, the controller 4A can realize the size of the first current I1 by calculating the cross voltage Vc. On the other hand, when the current transformer coil 52B is coupled to the second coil 24A-2, the operation is similar to the first coil 24A-1 and will not be described again. Since the current transformer coil 52B is only used to sense the shunt current (i.e., the sensing current Ia), its current value should not be too large. Therefore, the resistance value of the detection resistor Rs should not be too small. For example, but not limited to, a resistor with a resistance value above 10k is preferably configured. Therefore, the resistance value of the detection resistor Rs should not be too small. For example, but not limited to, a resistor with a resistance value above 10kΩ is preferably configured.

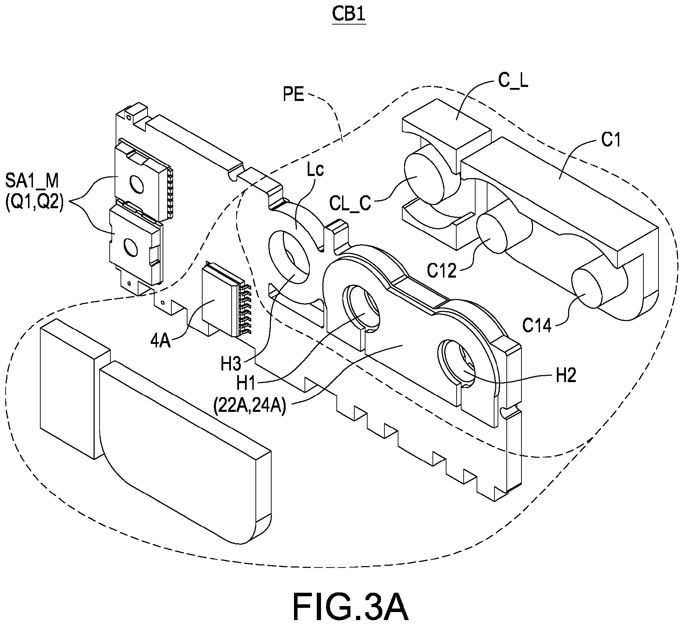

Please refer to FIG. 3A, which shows an exploded perspective view of the resonant converter of the present disclosure, and also refer to FIG. 2A. The resonant converter 100 is arranged/configured on the circuit board CB1, and the switch bridge arms SA1_M, SA1_N and the controller 4A are arranged in positions as shown in FIG. 3A. In particular, the resonant inductor Lr and the (at least one) transformer 2A form a planar magnetic component PE. Specifically, an inductor coil Lc of the resonant inductor Lr and the primary-side coil 22A and the secondary-side coil 24A of the transformer 2A are all planar structures, and the inductor coil Lc, the primary-side coil 22A and the secondary-side coil 24A are formed on PCB traces of the circuit board CB1. An iron core assembly includes an iron core C1 and an inductor iron core C_L. The (at least one) transformer 2A is formed by directly sleeving the iron core C1 on the primary-side coil 22A and the secondary-side coil 24A of the circuit board CB1, and the resonant inductor Lr is formed by directly sleeving the inductor iron core C_L on the inductor coil Lc of the circuit board CB1.

Therefore, the structure of the resonant converter 100 of the present disclosure mainly forms the inductor coil Lc of the resonant inductor Lr and the primary-side coil 22A and the secondary-side coil 24A of the transformer 2A on the circuit board CB1, so that the planar magnetic component PE can be planarized to significantly increase the space utilization of the resonant converter 100 and meet the requirement of the high power density. In addition, due to the small size of the planar magnetic component PE, the operating frequency of the resonant converter 100 can be significantly increased. Therefore, the power switches of the switch bridge arms SA1_M, SA1_N and the rectification circuit 32 can use third-generation semiconductor components such as the wide bandgap (WBG) as the main power switch, so that the resonant converter 100 has the advantages of higher efficiency, significantly reduced power switch size, lighter weight, and increased heat dissipation performance.

On the other hand, the current transformer coils 52A, 52B of the present disclosure also have a planar structure and are formed on the circuit board CB1. The current transformer coil 52A is formed near the inductor coil Lc and can induce the current flowing through the inductor coil Lc through coupling, and the current transformer coil 52A reuses the common-core structure of the inductor iron core C_L shared with the inductor coil Lc to form a current transformer for sensing the primary-side current. Therefore, under the above-mentioned common core structure, the circuit volume of the resonant converter 100 can be greatly reduced, and the space utilization of the resonant converter 100 can be greatly increased to meet high power density requirements.

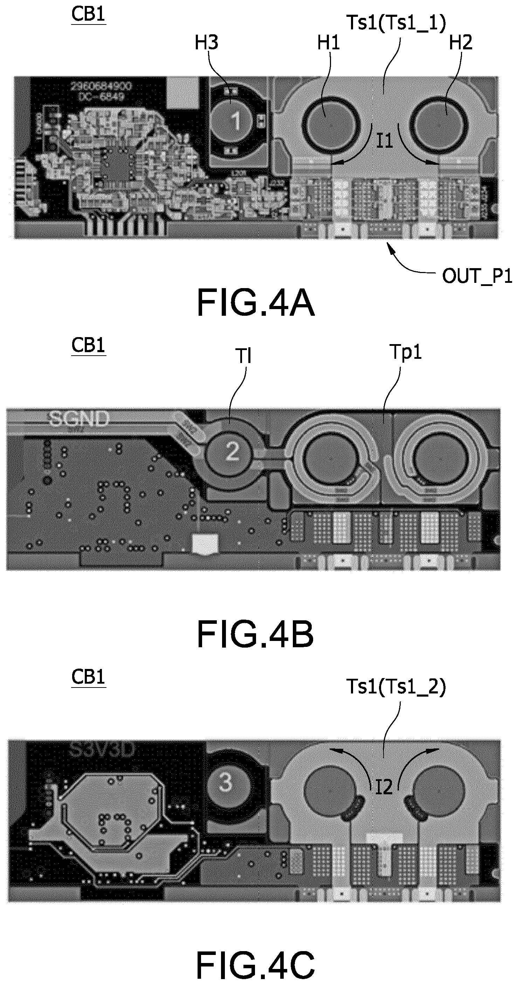

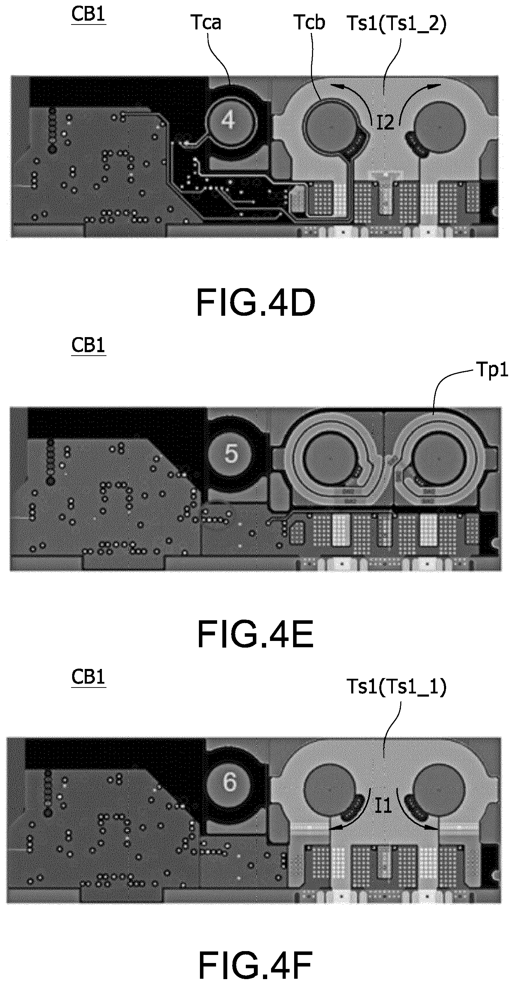

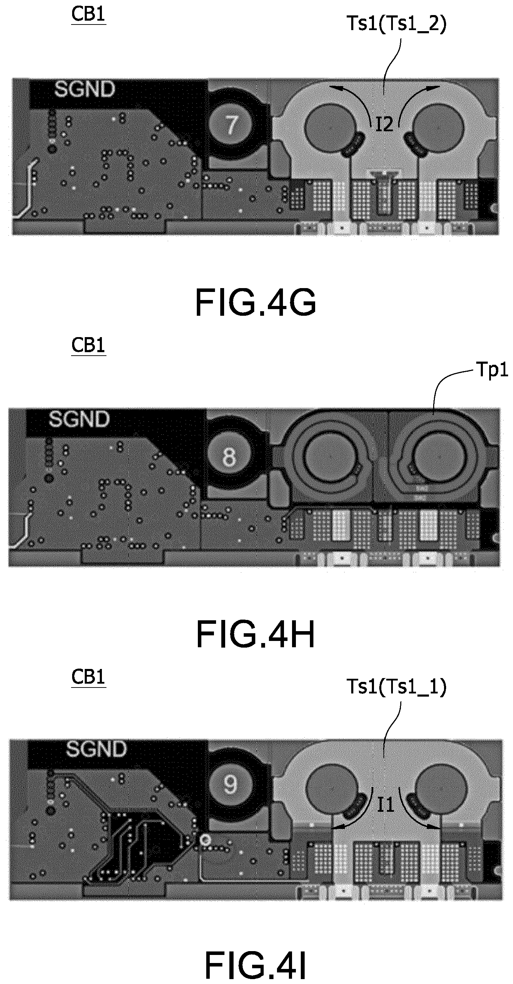

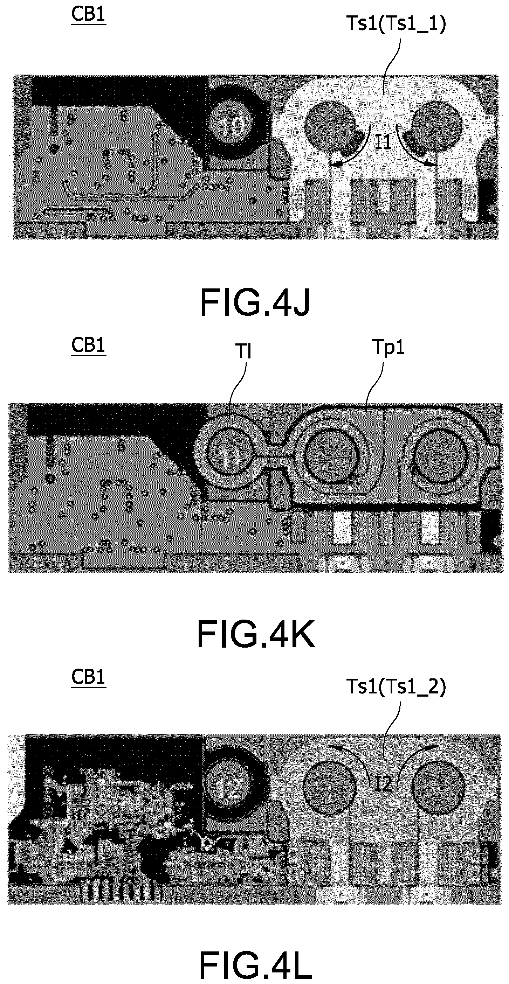

Please refer to FIG. 4A to FIG. 4L, which show schematic diagrams of the wiring of the coil of the planar magnetic component on each layer of the circuit board according to different embodiments of the present disclosure, and also refer to FIG. 2A to FIG. 3B. The circuit board CB1 is a multi-layer board (a 12-layer board is used as an example, but is not limited thereto), and FIG. 4A shows the top board, and FIG. 4L shows the bottom board. In particular, an inductor trace Tl serves as the inductor coil Lc, and a primary-side trace Tp1 serves as the primary-side coil 22A. The plurality of inductor traces Tl and the plurality of primary-side traces Tp1 are respectively formed on layer boards of FIG. 4B, FIG. 4E, FIG. 4H, and FIG. 4K (i.e., referred to as primary-side layer boards). Specifically, the inductor trace T1 can be connected in series through the connection of each primary-side layer board (for example, using via holes via) to form the inductor coil Lc. Similarly, the primary-side trace Tp1 can be connected in series through the communication of each primary-side layer board (for example, using via holes via) to serve as the primary-side coil 22A coupled to the primary-side circuit 1A. A plurality of secondary-side traces Ts1 serve as the secondary-side coil 24A and are formed on the layer boards of FIG. 4A, FIG. 4C, FIG. 4D, FIG. 4F, FIG. 4G, FIG. 4I, FIG. 4J, and FIG. 4L. Specifically, the secondary-side traces Ts1 can be connected in series through the connection of each secondary-side layer board (for example, using via holes via) to serve as a means for coupling the secondary-side coil 24A of the secondary-side circuit 3A.

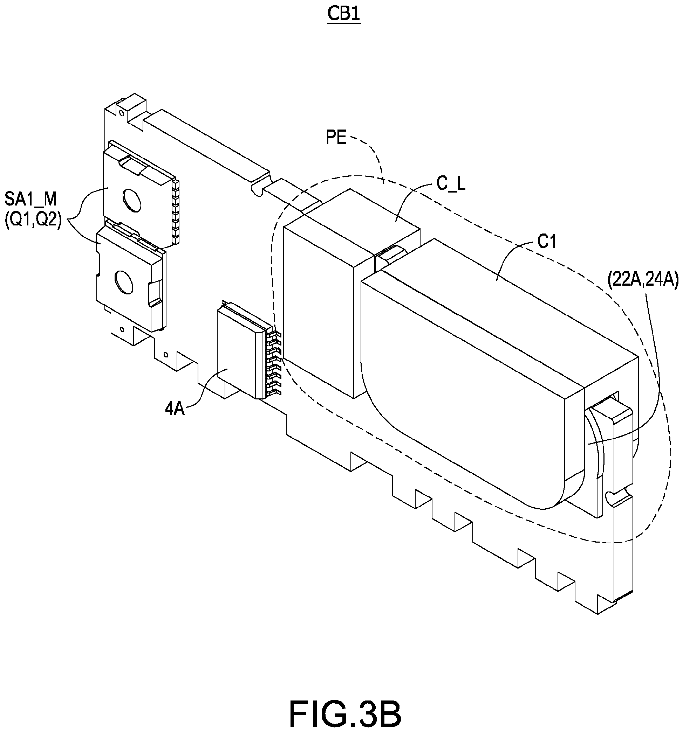

Please refer to FIG. 3A and FIG. 3B, the iron core C1 includes a first core pillar C12 and a second core pillar C14. The first core pillar C12 penetrates a first through hole H1 of the circuit board CB1, and the second core pillar C14 penetrates a second through hole H2 of the circuit board CB1. The primary-side traces Tp1 surround the first through hole H1 and the second through hole H2, and the secondary-side traces Ts1 also surround the first through hole H1 and the second through hole H2, so that after the iron core C1 is sleeved on the primary-side traces Tp1 and the secondary-side traces Ts1, closed magnetic paths can be formed in the transformer 2A. Similarly, the inductor iron core C_L includes a core pillar C_LC. The core pillar C_LC penetrates a third through hole H3 of the circuit board CB1. The inductor traces Tl surround the third through hole H3, so that after the inductor iron core C_L is sleeved on the inductor traces Tl, closed magnetic paths can be formed in the resonant inductor Lr. In particular, the material of the traces formed by each layer board may be copper foil, but it does not exclude the use of other metal foils that are easy to conduct electricity (such as, but not limited to, gold, silver, etc.).

In FIG. 4B, FIG. 4E, FIG. 4H, and FIG. 4K, the primary-side traces Tp1 surround the first through hole H1 in a first direction D1 (clockwise direction/counterclockwise direction), and surround the second through hole H2 in a second direction D2 (counterclockwise direction/clockwise direction) opposite to the first direction D1 to form ∞-shaped traces. That is, when the primary-side traces Tp1 surround the first through hole H1 in the clockwise direction, they will surround the second through hole H2 in the counterclockwise direction. On the contrary, when the primary-side traces Tp1 surround the first through hole H1 in the counterclockwise direction, they will surround the second through hole H2 in the clockwise direction. In one embodiment, the primary-side traces Tp1 shown in FIG. 4B, FIG. 4E, FIG. 4H, and FIG. 4K form two first primary-side coils 22A as shown in FIG. 3A. It can be inferred similarly that depending on the circuit configuration of the resonant converter 100, the primary-side traces Tp1 may form one or more than one first primary-side coils 22A. The number of the first primary-side coils 22A may be added depending on the number of layers of the circuit board CB1 and the number of turns of the primary-side traces Tp1, which will not be described again here.

In one embodiment, the primary-side traces Tp1 shown in FIG. 4B, FIG. 4E, FIG. 4H, and FIG. 4K form two primary-side coils 22A as shown in FIG. 3A. It can be inferred similarly that depending on the circuit configuration of the resonant converter 100, the primary-side traces Tp1 may form one or more than one primary-side coils 22A. The number of the primary-side coils 22A may be added depending on the number of layers of the circuit board CB1 and the number of turns of the primary-side traces Tp1, which will not be described again here.

In FIG. 4B, when the second rectification switch SR2 is turned on, the situation is exactly the opposite, that is, the primary-side traces Tp1 start from the first through hole H1 in the counterclockwise direction (i.e., the first direction D1), and approach the second through hole H2 in the clockwise direction (i.e., the second direction D2). The rest may be deduced by analogy, and no further details will be given. The first direction D1 and the second direction D2 refer to the current directions surrounding the first through hole H1 and the second through hole H2 as two different current directions, and are not limited to a clockwise direction or a counterclockwise direction. Therefore, the primary-side traces Tp1 surround the first through-hole H1 and the second through-hole H2 for at least two turns respectively, and similarly forms an ∞-shaped pattern, which is referred to as an ∞-shaped trace.

On the other hand, the primary-side traces Tp1 of the present disclosure further integrates the inductor traces Tl, and the inductor traces Tl surround the third through hole H3. Furthermore, as shown in FIG. 1, although the resonant inductor Lr is a different circuit component from the transformer 2A, in fact the two can be configured separately (that is, the two may include other circuit components, such as but not limited to, the resonant capacitor Cr), the circuit components of the two are similar in type and will also have a coil structure. Therefore, in the present disclosure, it is a preferred embodiment to integrate the inductor coil Lc of the resonant inductor Lr and the primary-side coils 22A to form the planar magnetic component PE, but it is not limited to this in practice. That is, the metal foil of the inductor trace Tl of the present disclosure is directly connected to the metal foil of the primary-side trace Tp1 to form a common trace structure.

On the other hand, in FIG. 4B, FIG. 4E, FIG. 4H, and FIG. 4K, although the metal foils of the inductor trace Tl and the primary-side trace Tp1 are located on the same layer and they are an integrally formed structure, the inductor trace Tl and the primary-side trace Tp1 can also be on different layers and coupled through via holes via. Therefore, the metal foil of the inductor trace T1 can be coupled to the primary-side trace Tp1 through coupling manner to form the same path. For example, but not limited to the via holes via, or other circuit components such as the resonant capacitor Cr between the two. Therefore, although the metal foil of the inductor trace T1 and the primary-side trace Tp1 is an integrally formed structure as shown in FIG. 4B, FIG. 4E, FIG. 4H, and FIG. 4K, the inductor trace Tl and the metal foil of the primary-side trace Tp1 can be configured separately, that is, the inductor trace Tl and the metal foil of the primary-side trace Tp1 in FIG. 4B, FIG. 4E, FIG. 4H, and FIG. 4K are disconnected, and coupled through via holes via or other circuit components that can be connected in series on this path. In one embodiment, the primary-side traces Tp1 shown in FIG. 4B, FIG. 4E, FIG. 4H, and FIG. 4K form two first primary-side coils 22A as shown in FIG. 2A. It can be inferred similarly that depending on the circuit configuration of the resonant converter 100, the primary-side traces Tp1 may form one or more than one primary-side coils 22A. The number of the first primary-side coils 22A may be added depending on the number of layers of the circuit board CB1 and the number of turns of the primary-side traces Tp1, which will not be described again here.

Furthermore, in the secondary-side traces Ts1 shown in FIG. 4A, FIG. 4C, FIG. 4D, FIG. 4F, FIG. 4G, FIG. 4I, FIG. 4J, and FIG. 4L, the secondary-side traces Ts1 form an m-shaped trace with the first through hole H1 and the second through hole H2. Moreover, the current flowing through the secondary-side trace Ts1 can flow out from the center point of the m-shape trace to two terminals respectively, or flow from the two terminals of the m-shape trace to the center point according to the actions of the rectification switches SR1, SR2, there will be further explanations later. The bottom of m-shape trace may include a plurality of via holes via. These via holes via are filled with conductive material inside, so that the secondary-side traces Ts1 of the secondary-side layer boards in FIG. 4A, FIG. 4C, FIG. 4D, FIG. 4F, FIG. 4G, FIG. 4I, FIG. 4J, and FIG. 4L can be electrically connected to each other through the via holes via.

Specifically, since the secondary-side coil 24A has a center-tapped winding structure, the secondary-side traces Ts1 respectively include at least one first trace Ts1_1 (as shown in FIG. 4A, FIG. 4F, FIG. 4I, and FIG. 4J) and at least one second trace Ts1_2 (as shown in FIG. 4C, FIG. 4D, FIG. 4G, and FIG. 4L). Therefore, the number of layers of the multi-layer circuit board CB1 may be at least three or more, so that the top layer, the middle layer, and the bottom layer can separately form one first trace Ts1_1, one second trace Ts1_2, and one trace integrating the primary-side trace Tp1 with the inductor trace Tl. When the number of layers increases, the number of the first trace Ts1_1, the second trace Ts1_2, the primary-side trace Tp1, and the inductor trace T1 can be selectively increased (based on circuit requirements). In particular, the secondary-side traces Ts1 of the secondary-side layer boards in FIG. 4A, FIG. 4F, FIG. 4I, and FIG. 4J can be connected through via holes via respectively to form two first coils 24A-1 (as shown in FIG. 2A). The secondary-side traces Ts1 of the secondary-side layer boards in FIG. 4C, FIG. 4D, FIG. 4G, and FIG. 4L can be connected through via holes via respectively to form two second coils 24A-2 (as shown in FIG. 3A). Similarly, the secondary-side traces Ts1 shown in FIG. 4A, FIG. 4C, FIG. 4D, FIG. 4F, FIG. 4G, FIG. 4I, FIG. 4J, and FIG. 4L can form two first secondary-side coils 24A as shown in FIG. 1. It can be inferred similarly that depending on the circuit configuration of the resonant converter 100, the secondary-side traces Ts1 may form one or more than one first secondary-side coils 24A. The number of the first secondary-side coils 24A may be added depending on the number of layers of the circuit board CB1 and the number of turns of the secondary-side traces Ts1, which will not be described again here.

Moreover, the first traces Ts1_1 surround the first through hole H1 and the second through hole H2 to form an m-shaped trace. Similarly, the second traces Ts1_2 also surround the first through hole H1 and the second through hole H2 to form an m-shaped trace. The difference between the two is that the current direction of the first trace Ts1_1 in FIG. 4A, FIG. 4F, FIG. 4I, and FIG. 4J flows from the two terminals of the m-shaped trace to the center point, and further to the first power output terminal OUT_P1 of the circuit board CB1. On the contrary, the current direction of the second trace Ts1_2 in FIG. 4C, FIG. 4D, FIG. 4G, and FIG. 4L is exactly opposite to that of the first trace Ts1_1, that is, the current direction flows from the center point of the m-shaped trace to the two terminals, and further to the first power output terminal OUT_P1 of the circuit board CB1.

In particular, the current transformer traces Tca, Tcb are shown in FIG. 4D, and the current transformer traces Tca, Tcb serve as current transformer coils 52A, 52B respectively. The current transformer trace Tca and the inductor trace Tl are arranged on different layer boards, and the current transformer trace Tca surrounds the third through hole H3 to couple the inductor trace Tl of the different layer board. Therefore, the circuit board CB1 can form a closed magnetic circuit after the inductor iron core C_L is sleeved on the inductor trace Tl and the current transformer trace Tca to constitute the resonant inductor Lr and the current transformer with a common iron core structure with the resonant inductor Lr. The current transformer trace Tcb and the second trace Ts1_2 are configured on the same layer board, and the current transformer trace Tcb and the second trace Ts1_2 of the secondary-side trace Ts1 have a concentric circle structure. On the other hand, the current transformer trace Tcb can also be configured on the same layer board as the first trace Ts1_1, and the current transformer trace Tcb and the second trace Ts1_2 of the secondary-side trace Ts1 have a concentric structure.

In FIG. 4D, the current transformer trace Tcb surrounds the first through hole H1 to couple the second trace Ts1_2 of the same layer board. Therefore, the circuit board CB1 can form a closed magnetic circuit to form the transformer 2A and a current transformer with a common core structure as the transformer 2A after the iron core C1 is sleeved on the primary-side trace Tp1, the secondary-side trace Ts1, and the current transformer trace Tcb. It is assumed that the current transformer trace Tcb and the first trace Ts1_1 are configured on the same layer board, and when the synchronous rectification switch SR1 is turned on, the current transformer trace Tcb can induce the first current I1 flowing through the first trace Ts1_1. On the contrary, it is assumed that the current transformer trace Tcb and the second trace Ts1_2 are configured on the same layer board, and when the synchronous rectification switch SR2 is turned on, the current transformer trace Tcb can induce the second current I2 flowing through the second trace Ts1_2. Since the synchronous rectification switch SR1 and the synchronous rectification switch SR2 (or diodes) are designed to be in complementary conduction (forward bias), when the synchronous rectification switch SR1 is turned on, the synchronous rectification switch SR2 is turned off, and vice versa. In particular, since the current transformer trace Tcb is disposed closer to the first through hole H1 than the second trace Ts1_2 of the secondary-side trace Ts1, a closed magnetic circuit is formed to form the transformer 2A and a current transformer having a common core structure with the transformer 2A after the iron core C1 is sleeved on the secondary-side trace Ts1 and the current transformer trace Tcb.

In particular, the current transformer trace Tca surrounding the third through hole H3 has a first area, and the inductor trace T1 surrounding the third through hole H3 has a second area. Since the current transformer is mainly used to sense the current flowing through the resonant inductor Lr, and the current flowing through the current transformer coil 52A is not too large, the first area must be smaller than the second area, and the area difference is preferably 1/5 to 1/10. Similarly, the current transformer trace Tcb surrounding the first through hole H1 has a third area, and the secondary-side traces Ts1 surrounding the first through hole H1 has a fourth area. In particular, the third area must be smaller than the fourth, and the area difference is preferably 1/5 to 1/10.

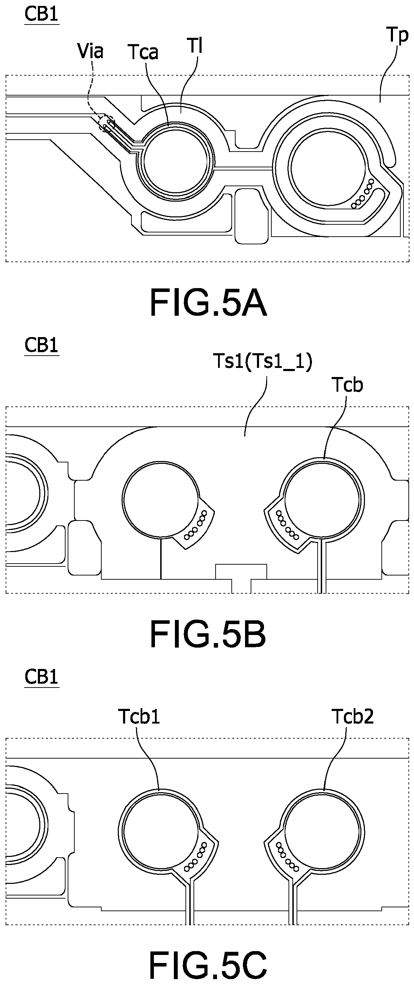

Please refer to FIG. 5A to FIG. 5C, which show schematic diagrams of the wiring of the coil of the planar magnetic component on each layer of the circuit board according to other different embodiments of the present disclosure, and also refer to FIG. 2A to FIG. 4L. The trace structures in FIG. 5A to FIG. 5C are only simple trace diagrams, so only the traces of the main components are shown, and the detailed structure can be easily inferred from the structures in FIG. 4A to FIG. 4L. In FIG. 5A, the current transformer trace Tca and the inductor trace Tl are arranged on the same layer board, and the current transformer trace Tca is disposed closer to the third through hole H3 than the inductor trace Tl. In particular, the current transformer trace Tca can be coupled to the current detection circuit (not shown) through, for example, but not limited to, a via hole via. In FIG. 5B, the current transformer trace Tcb and the first trace Ts1_1 are arranged on the same layer board, and the current transformer trace Tcb and the first trace Ts1_1 of the secondary-side trace Ts1 have a concentric structure. The current transformer trace Tcb surrounds the second through hole H2 to couple the first trace Ts1_1 that surrounds the second through hole H2 in the same layer board. Therefore, it is similar to FIG. 4D, when the synchronous rectification switch SR1 is turned on, the current transformer trace Tcb can induce the first current I1 flowing through the first trace Ts1_1. In particular, the current transformer trace Tcb is disposed closer to the second through hole H2 than the first trace Ts1_1 of the secondary-side trace Ts1 so that a closed magnetic circuit is formed to form the transformer 2A and a current transformer having a common core structure with the transformer 2A after the iron core C1 is sleeved on the secondary-side trace Ts1 and the current transformer trace Tcb.

In FIG. 5C, the current transformer trace Tcb includes a first current transformer trace Tcb 1 and a second current transformer trace Tcb2, and the second current transformer trace Tcb2 and the first current transformer trace Tcb1 are arranged on the same layer. In particular, this layer independently configures the first current transformer trace Tcb1 and the second current transformer trace Tcb2 (similar to the current transformer trace Tca FIG. 4D). This layer does not include any first trace Ts1_1 or second trace Ts1_2, but it does not exclude that the first current transformer trace Tcb1 and the second current transformer trace Tcb2 may be configured on the same layer as one of the first trace Ts1_1 and the second trace Ts1_2, as long as the second current transformer trace Tcb2 and the first current transformer trace Tcb1 are configured on the same layer. The first current transformer trace Tcb1 surrounds the first through hole H1, and the second current transformer trace Tcb2 surrounds the second through hole H2 to couple the first trace Ts1_1 and the second trace Ts1_2 of different layer boards. Since the synchronous rectification switch SR1 and the synchronous rectification switch SR2 (or diodes) are designed for complementary conduction (forward bias), when the synchronous rectification switch SR1 operates, the first current transformer trace Tcb1 and the second current transformer trace Tcb2 can induce the first current I1 flowing through the first trace Ts1_1. When the synchronous rectification switch SR2 operates, the first current transformer trace Tcb1 and the second current transformer trace Tcb2 can induce the second current I2 flowing through the second trace Ts1_2. In particular, the characteristics of the current transformer trace configuration of FIG. 4A to FIG. 5C may be applied interchangeably, and will not be described again here.

Since the current transformer coils 52A, 52B have a planar structure having current transformer traces Tca, Tcb, and are respectively integrated into the inductor trace Tl and the secondary-side trace Ts1 to form the structure of the planar magnetic component PE, the current detection can be achieved by utilizing the turn ratio of the current transformer traces Tca, Tcb to the inductor trace Tl and the secondary-side trace Ts1 respectively. Therefore, the resonant converter 100 can omit the current transformer primary-side coil 5A and the current transformer core of the current transformer 5, thereby reducing the contact resistance caused by the current transformer, increasing efficiency, and increasing power density. In addition, the use of integrated planar magnetic component PE can increase the space utilization of the resonant converter 100 and reduce the manpower assembly in the manufacturing process. Moreover, the primary-side coil 22A and the secondary-side coil 24A of the transformer 2A can be effectively distributed to reduce AC eddy current losses and increase efficiency.

## Claims

1. A planar magnetic component (PE) arranged on a circuit board (CB1) of a resonant converter (100), the resonant converter (100) comprising a primary-side circuit (1A) and a secondary-side circuit (3A), the planar magnetic component (PE) comprising:
an inductor trace (Tl) arranged on the primary-side circuit (1A) and formed on one layer board of the circuit board (CB1) to serve as a resonant inductor (Lr) electrically connected to the primary-side circuit (1A),
an inductor iron core (C_L) comprising a core pillar (C_LC), the core pillar (C_LC) penetrating a through hole (H3) of the circuit board (CB1), and the inductor trace (Tl) surrounding the through hole (H3),
an iron core (C1) comprising a first core pillar (C12) and a second core pillar (C14) respectively penetrating a first through hole (H1) and a second through hole of the circuit board (CB1),
a transformer (2A) comprising a primary-side trace (Tp1) surrounding the first through hole (H1) to serve as a primary-side coil (22A) electrically connected to the primary-side circuit (1A), and a secondary-side trace (Ts1) surrounding the second through hole (H2) to serve as a secondary-side coil (24A) electrically connected to the secondary-side circuit (3A),
**characterized by** a current transformer trace (Tca, Tcb) formed on the circuit board (CB1) to serve as a current transformer coil (52A, 52B) coupled to the resonant inductor (Lr),
wherein the current transformer trace (Tca, Tcb) surrounds the through hole (H3) to form a common-core structure that shares the inductor iron core (C_L), and
wherein the current transformer trace (Tca, Tcb) surrounding the through hole (H3) has a first area, and the inductor trace (Tl) surrounding the through hole (H3) has a second area, and the first area is less than the second area.

2. The planar magnetic component (PE) as claimed in claim 1, wherein the current transformer trace (Tca, Tcb) and the inductor trace (Tl) are arranged on the same layer board, and the current transformer trace (Tca, Tcb) is arranged in a position closer to the through hole (H3) than the inductor trace (Tl).

3. The planar magnetic component (PE) as claimed in claim 1, further comprising:
a primary-side trace (Tp1) formed on one layer board of the circuit board (CB1) to serve as a primary-side coil (22A) electrically connected to the primary-side circuit (1A),
wherein the primary-side trace (Tp1) surrounds a first through hole (H1) in a first direction and surrounds a second through hole (H2) in a second direction to form an ∞-shaped trace,
wherein a metal foil of the inductor trace (Tl) is electrically connected to a metal foil of the primary-side trace (Tp1).

4. The planar magnetic component (PE) as claimed in claim 3, wherein the metal foil of the inductor trace (Tl) and the metal foil of the primary-side trace (Tp1) have an integrally formed structure.

5. A planar magnetic component (PE) arranged on a circuit board (CB1) of a resonant converter (100), the resonant converter (100) comprising a primary-side circuit (1A) and a secondary-side circuit (3A), the planar magnetic component (PE) comprising:
an inductor iron core (C_L) comprising a core pillar (C_LC) penetrating a through hole (H3) of the circuit board (CB1),
an inductor trace (Tl) arranged on the primary-side circuit (1A) and surrounding the through hole (H3) to serve as a resonant inductor (Lr) electrically connected to the primary-side circuit (1A),
a primary-side trace (Tp1) formed on one layer board of the circuit board (CB1) to serve as a primary-side coil (22A) electrically connected to the primary-side circuit (1A),
a secondary-side trace (Ts1) formed on another layer board of the circuit board (CB1) to serve as a secondary-side coil (24A) electrically connected to the secondary-side circuit (3A),
an iron core (C1) comprising a first core pillar (C12) and a second core pillar (C14), the first core pillar (C12) and the second core pillar (C14) respectively penetrating a first through hole (H1) and a second through hole of the circuit board (CB1), and the primary-side trace (Tp1) and the secondary-side trace (Ts1) surrounding the first through hole (H1) and the second through hole (H2) to form a transformer (2A),
**characterized by** a current transformer trace (Tca, Tcb) formed on the circuit board (CB1) to serve as a current transformer coil (52A, 52B) coupled to the secondary-side coil (24A),
wherein the current transformer trace (Tca, Tcb) surrounds the first through hole (H1) or the second through hole (H2) to form a common-core structure that shares the iron core (C1), and
wherein the current transformer trace (Tca, Tcb) surrounding the first through hole (H1) or the second through hole (H2) has a third area, and the secondary-side trace (Ts1) surrounding the first through hole (H1) or the second through hole (H2) has a fourth area, and the third area is less than the fourth area.

6. The planar magnetic component (PE) as claimed in claim 5, wherein the current transformer trace (Tca, Tcb) and the secondary-side trace (Ts1) are arranged on the same layer board, and the current transformer trace (Tca, Tcb) is arranged in a position closer to the first through hole (H1) or the second through hole (H2) than the secondary-side trace (Ts1).

7. The planar magnetic component (PE) as claimed in claim 5, wherein the circuit board (CB1) is a multi-layer board, and the secondary-side coil (24A) has a center-tapped winding structure to form at least one first trace (Ts1_1) and at least one second trace (Ts1_2) on the circuit board (CB1); the at least one first trace (Ts1_1) surrounds the first through hole (H1) and the second through hole (H2) to form an m-shaped trace, and the at least one second trace (Ts1_2) surrounds the first through hole (H1) and the second through hole (H2) to form the m-shaped trace.

8. The planar magnetic component (PE) as claimed in claim 7, the current transformer trace (Tca, Tcb) surrounds the first through hole (H1) to couple the at least one first trace (Ts1_1) and the at least one second trace (Ts1 2).

9. The planar magnetic component (PE) as claimed in claim 7, the current transformer trace (Tca, Tcb) surrounds the second through hole (H2) to couple the at least one first trace (Ts1_1) and the at least one second trace (Ts1_2).

10. The planar magnetic component (PE) as claimed in claim 7, wherein the current transformer trace (Tca, Tcb) comprises:
a first current transformer trace (Tcb1) surrounding the first through hole (H1), and
a second current transformer trace (Tcb2) arranged on the same layer as the first current transformer trace (Tcb1) and surrounding the second through hole (H2),
wherein the first current transformer trace (Tcb1) is coupled to the at least one first trace (Ts1_1) and the at least one second trace (Ts1_2), and the second current transformer trace (Tcb2) is coupled to the at least one first trace (Ts1_1) and the at least one second trace (Ts1_2).

11. The planar magnetic component (PE) as claimed in claim 5, wherein the primary-side trace (Tp1) surrounds the first through hole (H1) in a first direction and surrounds the second through hole (H2) in a second direction to form an ∞-shaped trace.

12. The planar magnetic component (PE) as claimed in claim 5, wherein the planar magnetic component comprises an inductor trace (T1), and a metal foil of the inductor trace (Tl) is electrically connected to a metal foil of the primary-side trace (Tp1).

13. The planar magnetic component (PE) as claimed in claim 12, wherein the metal foil of the inductor trace (Tl) and the metal foil of the primary-side trace (Tp1) have an integrally formed structure.

## Patentansprüche

1. Planares magnetisches Bauteil (PE), das auf einer Leiterplatte (CB1) eines Resonanzwandlers (100) angeordnet ist, wobei der Resonanzwandler (100) eine primärseitige Schaltung (1A) und eine sekundärseitige Schaltung (3A) umfasst, wobei das planare magnetische Bauteil (PE) umfasst:
eine Induktionsspur (Tl), die auf der primärseitigen Schaltung (1A) angeordnet und auf einer Lagenplatte der Leiterplatte (CB1) ausgebildet ist, um als Resonanzinduktor (Lr) zu dienen, der elektrisch mit der primärseitigen Schaltung (1A) verbunden ist,
einen Induktions-Eisenkern (C_L), der eine Kernsäule (C_LC) umfasst, wobei die Kernsäule (C_LC) ein Durchgangsloch (H3) der Leiterplatte (CB1) durchdringt, und die Induktionsspur (Tl) das Durchgangsloch (H3) umgibt,
einen Eisenkern (C1) mit einer ersten Kernsäule (C12) und einer zweiten Kernsäule (C14), die jeweils ein erstes Durchgangsloch (H1) und ein zweites Durchgangsloch der Leiterplatte (CB1) durchdringen,
einen Transformator (2A) mit einer primärseitigen Leiterbahn (Tp1), die das erste Durchgangsloch (H1) umgibt, um als primärseitige Spule (22A) zu dienen, die elektrisch mit der primärseitigen Schaltung (1A) verbunden ist, und einer sekundärseitigen Leiterbahn (Ts1), die das zweite Durchgangsloch (H2) umgibt, um als sekundärseitige Spule (24A) zu dienen, die elektrisch mit der sekundärseitigen Schaltung (3A) verbunden ist,
**gekennzeichnet durch** eine Stromwandlerspur (Tca, Tcb), die auf der Leiterplatte (CB1) ausgebildet ist und als Stromwandlerspule (52A, 52B) dient, die mit der Resonanzspule (Lr) gekoppelt ist,
wobei die Stromwandlerspur (Tca, Tcb) das Durchgangsloch (H3) umgibt, um eine Struktur mit gemeinsamem Kern zu bilden, die den Induktionseisenkern (C_L) teilt, und
wobei die Stromwandlerspur (Tca, Tcb), die das Durchgangsloch (H3) umgibt, einen ersten Bereich aufweist und die Induktionsspur (Tl), die das Durchgangsloch (H3) umgibt, einen zweiten Bereich aufweist, und der erste Bereich kleiner als der zweite Bereich ist.

2. Planares magnetisches Bauteil (PE) nach Anspruch 1, wobei die Stromwandlerspur (Tca, Tcb) und die Induktionsspur (Tl) auf derselben Lagenplatte angeordnet sind und die Stromwandlerspur (Tca, Tcb) in einer Position angeordnet ist, die näher an dem Durchgangsloch (H3) liegt als die Induktionsspur (Tl).

3. Planares magnetisches Bauteil (PE) nach Anspruch 1, ferner umfassend:
eine primärseitige Leiterbahn (Tp1), die auf einer Lagenplatte der Leiterplatte (CB1) ausgebildet ist, um als primärseitige Spule (22A) zu dienen, die elektrisch mit der primärseitigen Schaltung (1A) verbunden ist,
wobei die primärseitige Leiterbahn (Tp1) ein erstes Durchgangsloch (H1) in einer ersten Richtung umgibt und ein zweites Durchgangsloch (H2) in einer zweiten Richtung umgibt, um eine∞ -förmige Leiterbahn zu bilden,
wobei eine Metallfolie der Induktorspur (Tl) elektrisch mit einer Metallfolie der primärseitigen Spur (Tp1) verbunden ist.

4. Planares magnetisches Bauteil (PE) nach Anspruch 3, wobei die Metallfolie der Induktionsspur (Tl) und die Metallfolie der primärseitigen Spur (Tp1) eine einstückig ausgebildete Struktur aufweisen.

5. Planares magnetisches Bauteil (PE), das auf einer Leiterplatte (CB1) eines Resonanzwandlers (100) angeordnet ist, wobei der Resonanzwandler (100) eine primärseitige Schaltung (1A) und eine sekundärseitige Schaltung (3A) umfasst, wobei das planare magnetische Bauteil (PE) umfasst:
einen Drossel-Eisenkern (C_L) mit einem Kernpfeiler (C_LC), der ein Durchgangsloch (H3) der Leiterplatte (CB1) durchdringt
eine Induktionsspur (Tl) , die auf der primärseitigen Schaltung (1A) angeordnet ist und das Durchgangsloch (H3) umgibt, um als Resonanzinduktor (Lr) zu dienen, der elektrisch mit der primärseitigen Schaltung (1A) verbunden ist,
eine primärseitige Leiterbahn (Tp1), die auf einer Lagenplatte der Leiterplatte (CB1) ausgebildet ist, um als primärseitige Spule (22A) zu dienen, die elektrisch mit der primärseitigen Schaltung (1A) verbunden ist,
eine sekundärseitige Leiterbahn (Ts1), die auf einer anderen Schichtplatte der Leiterplatte (CB1) ausgebildet ist, um als sekundärseitige Spule (24A) zu dienen, die elektrisch mit der sekundärseitigen Schaltung (3A) verbunden ist,
einen Eisenkern (C1), der eine erste Kernsäule (C12) und eine zweite Kernsäule (C14) umfasst, wobei die erste Kernsäule (C12) und die zweite Kernsäule (C14) jeweils ein erstes Durchgangsloch (H1) und ein zweites Durchgangsloch der Leiterplatte (CB1) durchdringen, und die primärseitige Leiterbahn (Tp1) und die sekundärseitige Leiterbahn (Ts1) das erste Durchgangsloch (H1) und das zweite Durchgangsloch (H2) umgeben, um einen Transformator (2A) zu bilden,
**gekennzeichnet durch** eine Stromwandlerspur (Tca, Tcb), die auf der Leiterplatte (CB1) ausgebildet ist und als Stromwandlerspule (52A, 52B) dient, die mit der sekundärseitigen Spule (24A) gekoppelt ist,
wobei die Stromwandlerspur (Tca, Tcb) das erste Durchgangsloch (H1) oder das zweite Durchgangsloch (H2) umgibt, um eine Struktur mit gemeinsamem Kern zu bilden, die den Eisenkern (C1) teilt, und
wobei die Stromwandlerspur (Tca, Tcb), die das erste Durchgangsloch (H1) oder das zweite Durchgangsloch (H2) umgibt, eine dritte Fläche aufweist, und die sekundärseitige Spur (Ts1), die das erste Durchgangsloch (H1) oder das zweite Durchgangsloch (H2) umgibt, eine vierte Fläche aufweist, und die dritte Fläche kleiner als die vierte Fläche ist.

6. Planares magnetisches Bauteil (PE) nach Anspruch 5, wobei die Stromwandlerbahn (Tca, Tcb) und die sekundärseitige Bahn (Ts1) auf derselben Lagenplatte angeordnet sind und die Stromwandlerbahn (Tca, Tcb) in einer Position angeordnet ist, die näher an dem ersten Durchgangsloch (H1) oder dem zweiten Durchgangsloch (H2) liegt als die sekundärseitige Bahn (Ts1).

7. Planares magnetisches Bauteil (PE) nach Anspruch 5, wobei die Leiterplatte (CB1) eine mehrlagige Platte ist und die sekundärseitige Spule (24A) eine mittig angezapfte Wicklungsstruktur aufweist, um mindestens eine erste Leiterbahn (Ts1_1) und mindestens eine zweite Leiterbahn (Ts1_2) auf der Leiterplatte (CB1) zu bilden; die mindestens eine erste Leiterbahn (Ts1_1) das erste Durchgangsloch (H1) und das zweite Durchgangsloch (H2) umgibt, um eine m-förmige Leiterbahn zu bilden, und die mindestens eine zweite Leiterbahn (Ts1_2) das erste Durchgangsloch (H1) und das zweite Durchgangsloch (H2) umgibt, um die m-förmige Leiterbahn zu bilden.

8. Planares magnetisches Bauteil (PE) nach Anspruch 7, wobei die Stromwandlerspur (Tca, Tcb) das erste Durchgangsloch (H1) umgibt, um die mindestens eine erste Spur (Ts1_1) und die mindestens eine zweite Spur (Ts1_2) zu koppeln.

9. Planares magnetisches Bauteil (PE) nach Anspruch 7, wobei die Stromwandlerspur (Tca, Tcb) das zweite Durchgangsloch (H2) umgibt, um die mindestens eine erste Spur (Ts1_1) und die mindestens eine zweite Spur (Ts1_2) zu koppeln.

10. Planares magnetisches Bauteil (PE) nach Anspruch 7, wobei die Stromwandlerspur (Tca, Tcb) umfasst:
eine erste Stromwandlerspur (Tcb1), die das erste Durchgangsloch (H1) umgibt, und
eine zweite Stromwandlerbahn (Tcb2), die auf derselben Schicht wie die erste Stromwandlerbahn (Tcb1) angeordnet ist und das zweite Durchgangsloch (H2) umgibt,
wobei die erste Stromwandlerspur (Tcb1) mit der mindestens einen ersten Spur (Ts1_1) und der mindestens einen zweiten Spur (Ts1_2) gekoppelt ist, und die zweite Stromwandlerspur (Tcb2) mit der mindestens einen ersten Spur (Ts1_1) und der mindestens einen zweiten Spur (Ts1_2) gekoppelt ist.

11. Planares magnetisches Bauteil (PE) nach Anspruch 5, wobei die primärseitige Spur (Tp1) das erste Durchgangsloch (H1) in einer ersten Richtung umgibt und das zweite Durchgangsloch (H2) in einer zweiten Richtung umgibt, um eine ∞-förmige Spur zu bilden.

12. Planares magnetisches Bauteil (PE) nach Anspruch 5, wobei das planare magnetische Bauteil eine Induktionsspur (T1) umfasst und eine Metallfolie der Induktionsspur (Tl) elektrisch mit einer Metallfolie der primärseitigen Spur (Tp1) verbunden ist.

13. Planares magnetisches Bauteil (PE) nach Anspruch 12, wobei die Metallfolie der Induktionsspur (Tl) und die Metallfolie der primärseitigen Spur (Tp1) eine einstückig ausgebildete Struktur aufweisen.

## Revendications

1. Un composant magnétique planaire (PE) disposé sur une carte de circuit imprimé (CB1) d'un transducteur résonant (100), le transducteur résonant (100) comprenant un circuit côté primaire (1A) et un circuit côté secondaire (3A), dans lequel le composant magnétique planaire comprend (PE) :
une piste d'induction (Tl) disposée sur le circuit côté primaire (1A) et formée sur une plaque de couche de la carte de circuit imprimé (CB1) pour servir d'inducteur de résonance (Lr) connecté électriquement au circuit côté primaire (1A),
un noyau de fer d'induction (C_L) comprenant une colonne de noyau (C_LC), la colonne de noyau (C_LC) pénétrant dans un trou traversant (H3) de la carte de circuit imprimé (CB1), et la piste d'induction (Tl) entourant le trou traversant (H3),
un noyau de fer (C1) comprenant une première colonne de noyau (C12) et une deuxième colonne de noyau (C14) qui traversent respectivement un premier trou de passage (H1) et un deuxième trou de passage de la carte de circuit imprimé (CB1),
un transformateur (2A) comprenant une piste conductrice côté primaire (Tp1) entourant le premier trou traversant (H1) pour servir de bobine côté primaire (22A) connectée électriquement au circuit côté primaire (1A), et une piste conductrice côté secondaire (Ts1) entourant le second trou traversant (H2) pour servir de bobine côté secondaire (24A) connectée électriquement au circuit côté secondaire (3A),
**caractérisé par** une piste de transformateur de courant (Tca, Tcb) formée sur ladite carte de circuit imprimé (CB1) et servant de bobine de transformateur de courant (52A, 52B) couplée à ladite bobine de résonance (Lr),
dans lequel la piste de transformateur de courant (Tca, Tcb) entoure le trou traversant (H3) pour former une structure à noyau commun qui divise le noyau de fer d'induction (C_L), et
dans lequel la piste de transformateur de courant (Tca, Tcb) entourant le trou traversant (H3) a une première zone et la piste d'induction (Tl) entourant le trou traversant (H3) a une seconde zone, et la première zone est plus petite que la seconde zone.

2. Le composant magnétique planaire (PE) selon la revendication 1, dans lequel la piste de transformateur de courant (Tca, Tcb) et la piste d'induction (Tl) sont disposées sur la même plaque de couche et la piste de transformateur de courant (Tca, Tcb) est disposée dans une position plus proche du trou traversant (H3) que la piste d'induction (Tl).

3. Le composant magnétique planaire (PE) selon la revendication 1, comprenant en outre :
une piste conductrice côté primaire (Tp1) formée sur une plaque de couche de la carte de circuit imprimé (CB1) pour servir de bobine côté primaire (22A) connectée électriquement au circuit côté primaire (1A),
dans lequel la piste conductrice côté primaire (Tp1) entoure un premier trou traversant (H1) dans une première direction et entoure un second trou traversant (H2) dans une seconde direction pour former une piste conductrice en forme de∞ ,
dans lequel une feuille métallique de la piste d'inducteur (Tl) est connectée électriquement à une feuille métallique de la piste du côté primaire (Tp1).

4. Le composant magnétique planaire (PE) selon la revendication 3, dans lequel la feuille métallique de la piste d'induction (Tl) et la feuille métallique de la piste du côté primaire (Tp1) présentent une structure formée d'un seul tenant.

5. Le composant magnétique planaire (PE) disposé sur une carte de circuit imprimé (CB1) d'un transducteur résonant (100), le transducteur résonant (100) comprenant un circuit côté primaire (1A) et un circuit côté secondaire (3A), dans lequel le composant magnétique planaire comprend (PE) :
un noyau de fer de bobine d'arrêt (C_L) avec un pilier de noyau (C_LC) qui pénètre dans un trou de passage (H3) de la carte de circuit imprimé (CB1)
une piste d'induction (Tl) , disposée sur le circuit côté primaire (1A) et entourant le trou traversant (H3) pour servir d'inducteur de résonance (Lr) connecté électriquement au circuit côté primaire (1A),
une piste conductrice côté primaire (Tp1) formée sur une plaque de couche de la carte de circuit imprimé (CB1) pour servir de bobine côté primaire (22A) connectée électriquement au circuit côté primaire (1A),
une piste conductrice côté secondaire (Ts1) formée sur une autre plaque de couche de la carte de circuit imprimé (CB1) pour servir de bobine côté secondaire (24A) connectée électriquement au circuit côté secondaire (3A),
un noyau de fer (C1) comprenant une première colonne de noyau (C12) et une deuxième colonne de noyau (C14), la première colonne de noyau (C12) et la deuxième colonne de noyau (C14) pénétrant respectivement dans un premier trou traversant (H1) et un deuxième trou traversant de la carte de circuit imprimé (CB1), et la piste conductrice côté primaire (Tp1) et la piste conductrice côté secondaire (Ts1) entourent le premier trou traversant (H1) et le deuxième trou traversant (H2) pour former un transformateur (2A),
**caractérisé par** une piste de transformateur de courant (Tca, Tcb) formée sur la carte de circuit imprimé (CB1) et servant de bobine de transformateur de courant (52A, 52B) couplée à la bobine du côté secondaire (24A),
dans lequel la piste de transformateur de courant (Tca, Tcb) entoure le premier trou traversant (H1) ou le second trou traversant (H2) pour former une structure à noyau commun qui divise le noyau de fer (C1), et
dans lequel la piste de transformateur de courant (Tca, Tcb) entourant le premier trou traversant (H1) ou le deuxième trou traversant (H2) a une troisième surface, et la piste côté secondaire (Ts1) entourant le premier trou traversant (H1) ou le deuxième trou traversant (H2) a une quatrième surface, et la troisième surface est inférieure à la quatrième surface.

6. Le composant magnétique planaire (PE) selon la revendication 5, dans lequel la piste de transformateur de courant (Tca, Tcb) et la piste côté secondaire (Ts1) sont disposées sur la même plaque de couche et la piste de transformateur de courant (Tca, Tcb) est disposée dans une position plus proche du premier trou traversant (H1) ou du second trou traversant (H2) que la piste côté secondaire (Ts1).

7. Le composant magnétique planaire (PE) selon la revendication 5, dans lequel la carte de circuit imprimé (CB1) est une carte multicouche et la bobine côté secondaire (24A) comprend une structure d'enroulement à prise centrale pour former au moins une première piste conductrice (Ts1_1) et au moins une deuxième piste conductrice (Ts1_2) sur la carte de circuit imprimé (CB1) ; la au moins une première piste conductrice (Ts1_1) entoure le premier trou traversant (H1) et le deuxième trou traversant (H2) pour former une piste conductrice en forme de m, et la au moins une deuxième piste conductrice (Ts1_2) entoure le premier trou traversant (H1) et le deuxième trou traversant (H2) pour former la piste conductrice en forme de m.

8. Le composant magnétique planaire (PE) selon la revendication 7, dans lequel la piste de transformateur de courant (Tca, Tcb) entoure le premier trou traversant (H1) pour coupler la au moins une première piste (Ts1_1) et la au moins une deuxième piste (Ts1_2).

9. Le composant magnétique planaire (PE) selon la revendication 7, dans lequel la piste de transformateur de courant (Tca, Tcb) entoure le deuxième trou traversant (H2) pour coupler la au moins une première piste (Ts1_1) et la au moins une deuxième piste (Ts1_2).

10. Le composant magnétique planaire (PE) selon la revendication 7, dans lequel la piste de transformateur de courant comprend (Tca, Tcb) :
une première piste de transformateur de courant (Tcb1) entourant le premier trou de passage (H1), et
une deuxième piste de transformateur de courant (Tcb2) disposée sur la même couche que la première piste de transformateur de courant (Tcb1) et entourant le deuxième trou traversant (H2),
dans lequel la première piste de transformateur de courant (Tcb1) est couplée à ladite au moins une première piste (Ts1_1) et à ladite au moins une deuxième piste (Ts1_2), et la deuxième piste de transformateur de courant (Tcb2) est couplée à ladite au moins une première piste (Ts1_1) et à ladite au moins une deuxième piste (Ts1_2).

11. Le composant magnétique planaire (PE) selon la revendication 5, dans lequel la piste côté primaire (Tp1) entoure le premier trou traversant (H1) dans une première direction et entoure le deuxième trou traversant (H2) dans une deuxième direction pour former une piste en forme de ∞.

12. Le composant magnétique planaire (PE) selon la revendication 5, dans lequel le composant magnétique planaire comprend une piste d'induction (T1) et une feuille métallique de la piste d'induction (Tl) est connectée électriquement à une feuille métallique de la piste du côté primaire (Tp1).

13. Le composant magnétique planaire (PE) selon la revendication 12, dans lequel la feuille métallique de la piste d'induction (Tl) et la feuille métallique de la piste du côté primaire (Tp1) présentent une structure formée d'un seul tenant.
